# EUROPEAN PATENT APPLICATION

(11) **EP 4 513 560 A2**
(43) Date of publication of application: **26.02.2025**
(21) Application number: 24716612.7
(22) Date of filing: 04.04.2024
(51) Int. Cl.: H01L 25/075, H10H 20/84, H10H 20/857, H10H 20/852, H10H 20/85, H05K 1/18, H05K 3/28

(54) **DISPLAY MODULE AND MANUFACTURING METHOD THEREOF**

(30) Priority: 04.07.2023 KR 20230086612
(71) Applicant: Samsung Electronics Co., Ltd., Suwon-si, Gyeonggi-do 16677 (KR)
(72) Inventor: KIM, Dooyoung, Suwon-si, Gyeonggi-do 16677 (KR); JUNG, Jaewon, Suwon-si, Gyeonggi-do 16677 (KR)
(74) Representative: Walaski, Jan Filip
(86) International application number: PCT/KR2024/004411
(87) International publication number: WO 2025/009702

(57) **Abstract**

Disclosed is a display module. The display module includes a printed circuit board having a conductive pattern formed thereon, a plurality of light emitting elements arranged on the printed circuit board, and electrically connected to the conductive pattern, and a filling layer including an opaque non-conductive material, wherein the printed circuit board comprises a protruding structure disposed in an outer region of the printed circuit board between outermost ones of the light emitting elements and an edge of the printed circuit board, wherein the height of the protruding structure is greater than the height of the conductive pattern, wherein the filling layer is disposed between the plurality of light emitting elements and between the outermost light emitting elements and the protruding structure to cover the conductive pattern.

## Description

### [Technical Field]

The disclosure relates to a display module and a manufacturing method thereof, and more particularly, to a display module in which a filling material is formed evenly between a light emitting diode (LED) element and a protruding structure by using a printed circuit board having the protruding structure formed on its outer region, and a manufacturing method thereof.

### [Background Art]

In general, a light emitting diode (LED) display may have a plurality of LED elements mounted at a predetermined gap. The LED display may be a next-generation display that replaces a conventional liquid crystal display, and have a high color reproduction and a brighter image quality.

In the LED display, an LED display having a specific resolution may be formed as a unit module (hereinafter, "a display module"), and one display may be produced by connecting several display modules with each other in a matrix.

### [Disclosure]

### [Technical Solution]

According to the invention, there is provided a display module comprising a printed circuit board having a conductive pattern formed thereon; a plurality of light emitting elements arranged on the printed circuit board, and electrically connected to the conductive pattern; and a filling layer including an opaque non-conductive material; wherein the printed circuit board comprises a protruding structure disposed in an outer region of the printed circuit board between outermost ones of the light emitting elements and an edge of the printed circuit board, wherein the height of the protruding structure is greater than the height of the conductive pattern; wherein the filling layer is disposed between the plurality of light emitting elements and between the outermost light emitting elements and the protruding structure to cover the conductive pattern.

The height of the protruding structure may be less than the height of the top surface of each of the plurality of light emitting elements.

The protruding structure may comprise a copper foil layer, a solder resist layer and a silk ink layer that are sequentially stacked on the printed circuit board.

The copper foil layer may have has the same height as the conductive pattern, and the solder resist layer may have the same height as a resist pattern formed to protect the conductive pattern.

The protruding structure may comprise a solder resist layer and a silk ink layer that are sequentially stacked on the printed circuit board.

The protruding structure may surround the plurality of light emitting elements.

The protruding structure may be spaced apart from the outermost light emitting elements among the plurality of light emitting elements by a predetermined gap, wherein the predetermined gap is the same as or is half the gap between adjacent ones of the plurality of light emitting elements.

The module may further comprise a molding layer disposed on the plurality of light emitting elements and the filling layer and a film layer disposed on the molding layer.

Each of the plurality of light emitting elements may be at least one of a red (R) light emitting element, a green (G) light emitting element, or a blue (B) light emitting element, and at least one R light emitting element, at least one G light emitting element, and at least one B light emitting element among the plurality of light emitting elements may be operated as one pixel.

The height of the filling layer may be less than the height of the top surface of each of the plurality of light emitting elements.

According to the invention, there is provided a manufacturing method of a display module, the method comprising preparing a printed circuit board having a conductive pattern formed thereon and a protruding structure in an outer region of the printed circuit board connecting a plurality of light emitting elements to the conductive pattern and depositing an opaque non-conductive material between the plurality of light emitting elements and between outermost ones of the light emitting elements and the protruding structure to form a filling layer to cover the conductive pattern.

In the filling of the opaque non-conductive material, the opaque non-conductive material may be discharged to fill the printed circuit board to a height corresponding to the height of the protruding structure.

The method may further comprise forming a molding layer on the plurality of light emitting elements and the filling layer; forming a film layer on the molding layer; and cutting the outer region of the printed circuit board on which the film layer is formed.

The molding layer may be formed using a transparent material.

Each light emitting element may be connected to the printed circuit board by using a flip chip method.

### [Description of Drawings]

FIG. 1 is a view showing one display device formed by arranging display modules in a matrix form;
FIG. 2 is a view showing one of the plurality of display modules shown in FIG. 1;
FIG. 3 is a view showing an arrangement example of light emitting elements;
FIG. 4 is a view showing another arrangement example of the light emitting elements;
FIG. 5 is a cross-sectional view of the display module taken along line III-III shown in FIG. 2;
FIG. 6 is a cross-sectional view of the display module taken along line III-III shown in FIG. 2;
FIG. 7 is a view showing an example of the display module according to an embodiment of the invention;
FIG. 8 is a flowchart for explaining a manufacturing method of a display module according to an embodiment of the invention;
FIG. 9 is a plan view for explaining a printed circuit board according to an embodiment of the invention;
FIGS. 10, 11, and 12 are views for explaining a manufacturing method of a printed circuit board according to an embodiment of the invention;
FIGS. 13, 14, and 15 are views for explaining a manufacturing method of a printed circuit board according to an embodiment of the invention;
FIG. 16 is a view for explaining a state where the light emitting element is disposed on the printed circuit board;
FIG. 17 is a view showing a state where a non-conductive material completely fills a space between the respective light emitting elements of the display module and a space between the outermost light emitting element and a protruding structure;
FIG. 18 is a view showing a state of the printed circuit board formed with a molding layer;
FIG. 19 is a view showing a state of the printed circuit board formed with a film layer;
FIG. 20 is a view for explaining a process of cutting an outer region; and
FIG. 21 is a view showing a cut result of FIG. 20.

### [Mode for Invention]

The disclosure may be variously modified and have several embodiments, and specific embodiments of the disclosure are thus shown in the drawings and described in detail in the detailed description. However, it is to be understood that the scope of the invention is not limited to the specific embodiments, and include various modifications, equivalents, and/or alternatives that fall within the scope of the claims. Throughout the accompanying drawings, similar components are denoted by similar reference numerals.

In describing the disclosure, the description omits a detailed description of a case where the detailed description of the known functions or configurations related to the disclosure is determined to unnecessarily obscure the gist of the disclosure.

Terms used in the disclosure are used only to describe the specific embodiments rather than limiting the scope of the disclosure.

In the disclosure, an expression "have", "may have", "include", "may include" or the like, indicates existence of a corresponding feature (for example, a numerical value, a function, an operation, or a component such as a part), and does not exclude existence of an additional feature.

In the disclosure, expressions "A or B", "least one of A and/or B", "one or more of A and/or B" and the like, may include all possible combinations of items enumerated together. For example, "A or B", "at least one of A and B" or "at least one of A or B" may indicate all of 1) a case where at least one A is included, 2) a case where at least one B is included, or 3) a case where both of at least one A and at least one B are included.

Expressions "first", "second" and the like, used in the disclosure, may indicate various components regardless of the sequence or importance of the components. The expression is used only to distinguish one component from another component, and does not limit the corresponding component.

In case that any component (for example, a first component) is mentioned to be "(operatively or communicatively) coupled with/to" or "connected to" another component (for example, a second component), it is to be understood that any component is directly coupled to another component or coupled to another component through still another component (for example, a third component).

On the other hand, in case that any component (for example, the first component) is mentioned to be "directly coupled to" or "directly connected to" another component (for example, the second component), it is to be understood that still other component (for example, the third component) is not present between any component and another component.

An expression "configured (or set) to" used in the disclosure may be replaced by an expression "suitable for", "having the capacity to", "designed to", "adapted to", "made to" or "capable of" based on a situation. The expression "configured (or set) to" may not necessarily indicate "specifically designed to" in hardware.

Instead, an expression "a device configured to" in any situation may indicate that the device may "perform~" together with another device or component. For example, "a processor configured (or set) to perform A, B and C" may indicate a dedicated processor (for example, an embedded processor) that may perform the corresponding operations or a generic-purpose processor (for example, a central processing unit (CPU) or an application processor) that may perform the corresponding operations by executing one or more software programs stored in a memory device.

In the embodiments, a "module" or a "~er/or" may perform at least one function or operation, and be implemented by hardware or software or be implemented by a combination of hardware and software. In addition, a plurality of "modules" or a plurality of "~ers/ors" may be integrated with each other in at least one module and implemented by at least one processor except for a "module" or an "~er/or" that needs to be implemented in specific hardware.

Operations performed by the modules, the programs, or other components according to the various embodiments may be executed in a sequential manner, a parallel manner, an iterative manner, or a heuristic manner, at least some of the operations may be performed in a different order or be omitted, or other operations may be added.

Meanwhile, various elements and regions in the drawings are schematically shown. Therefore, the disclosure is not limited by relative sizes or intervals shown in the accompanying drawings.

Meanwhile, an electronic device according to the various embodiments of the disclosure may include, for example, at least one of a smartphone, a tablet personal computer (PC), a desktop PC, a laptop PC, or a wearable device. The wearable device may include at least one of an accessory type (for example, a watch, a ring, a bracelet, an anklet, a necklace, a glasses, a contact lens, or a head-mounted-device (HMD)), a textile or clothing integral type (for example, an electronic clothing), a body attachment type (for example, a skin pad or a tattoo), or a living body implantation type circuit.

In some embodiments, the electronic device may be various devices including a display among a television, a digital video disk (DVD) player, an audio player, a refrigerator, an air conditioner, a vacuum cleaner, an oven, a microwave oven, a washing machine, an air purifier, a set-top box, a home automation control panel, a security control panel, a media box (e.g., Samsung HomeSyncTM, Apple TVTM or Google TVTM), a game console (e.g., XboxTM or PlayStationTM), an electronic dictionary, an electronic key, a camcorder, or an electronic picture frame.

Hereinafter, the embodiments of the disclosure are described in detail with reference to the accompanying drawings so that those skilled in the art to which the disclosure pertains may easily practice the disclosure.

Hereinafter, the various embodiments of the disclosure are described with reference to the accompanying drawings. However, it is to be understood that technology mentioned in the disclosure is not limited to the specific embodiments, and includes all modifications, equivalents, and alternatives while still falling within the scope of the claims.

In addition, exemplary dimensions used in the disclosure that correspond to a size w1 X w2 X h1 of a light emitting element, a pitch g1 between the respective light emitting elements, a height of a filling layer, and the like may indicate that the size of the light emitting element disposed in a display module according to an embodiment of the disclosure is small or ultra-small.

In addition, the terms used in the disclosure may be used only to describe the specific embodiments rather than restricting the scope of another embodiment. A term of a singular number may include its plural number unless explicitly indicated otherwise. Terms used in the specification including technical and scientific terms have the same meanings as those that are generally understood by those skilled in the art to which the disclosure pertains.

Terms defined by a general dictionary among the terms used in the disclosure may be interpreted as meaning that are the same as or similar to meanings within a context of the related art, and are not interpreted as ideal or excessively formal means unless clearly defined in the disclosure. In some cases, terms may not be interpreted to exclude the embodiments of the disclosure even though these terms are defined in the disclosure.

Hereinafter, the description describes a configuration of the display module according to embodiments of the invention with reference to the accompanying drawings, and sequentially describes a manufacturing method of a display module.

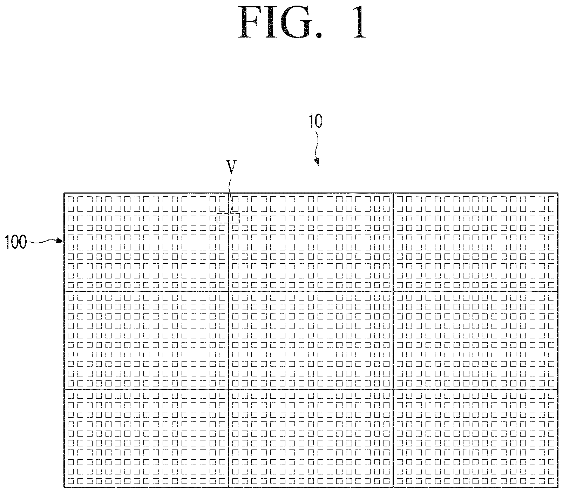

FIG. 1 is a view showing one display device 10 formed by arranging display modules 100 in a matrix form.

Referring to FIG. 1, the display device 10 may be one device formed by arranging the plurality of display modules 100 to be connected with each other. Meanwhile, the illustrated example shows that the plurality of display modules 100 are arranged in the matrix form. However, the display modules may be implemented to be arranged only in a series or parallel form other than in the matrix form, or in various forms other than a square form.

The display device 10 may include a driver (not shown) driving each of the display modules 100, a controller (not shown) controlling the driver, a power supplier (not shown), and a plurality of wires (not shown) for receiving various signals.

The plurality of light emitting elements may be arranged in the display module 100. In detail, the display module 100 may include a plurality of pixels, and each pixel may include a subpixel. The subpixels may include a R subpixel, a G subpixel, and a B subpixel.

The R subpixel may include a red (R) light emitting element emitting red color light, the G subpixel may include a green (G) light emitting element emitting green color light, and the B subpixel may include a blue (B) light emitting element emitting blue color light.

The inorganic light emitting element may indicate a light emitting element manufactured using an inorganic material, which is different from an organic light emitting diode (OLED) manufactured using an organic material. Accordingly, the light emitting element may also be referred to as an inorganic light emitting element. The light emitting element may also be referred to as a micro light emitting diode (i.e., a micro LED or a µLED).

The display module 100, in which each subpixel is implemented as the micro LED, may be referred to as a micro LED display module (or an LED display panel). The micro LED display module may be one of flat display panels, in which the micro light emitting diode may be disposed. The micro LED display panel may provide better contrast, response time and energy efficiency compared to a liquid crystal display (LCD) panel that requires a backlight.

Meanwhile, both of the organic light emitting diode (OLED) and the micro LED may have good energy efficiency. However, the micro LED may provide better performance than the OLED in terms of brightness, luminous efficiency, and lifespan. In particular, the OLED may use an organic compound, and due to a feature of this organic material, the OLED may be vulnerable to a burn-in phenomenon, and thus be less suitable for pulse width modulation (PWM) driving than the micro LED which is the inorganic light emitting element.

The light emitting element may express a grayscale value of different brightness based on a magnitude of a driving current provided from a pixel circuit (not shown) and/or a pulse width of the driving current. Here, the pulse width of the driving current may be referred to as a duty ratio of the driving current or a driving time (or duration) of the driving current.

For example, the light emitting element may express a brighter grayscale value as the driving current has a greater magnitude. In addition, the light emitting element may express the brighter grayscale value as the driving current has a larger pulse width (i.e., a higher duty ratio or a longer driving time).

The pixel circuit may provide the driving current to the light emitting element in case that the display module 100 is driven. The pixel circuit may provide the driving current having controlled magnitude and driving time to the light emitting element based on an image data voltage (e.g., a constant current source data voltage and/or a PWM data voltage.) That is, the pixel circuit may control brightness of light emitted by the inorganic light emitting element by driving the light emitting element through a pulse amplitude modulation (PAM) driving and/or the PWM driving.

For this purpose, the pixel circuit may include a constant current source circuit and a PWM circuit. Each of the constant current source circuit and the PWM circuit may be a transistor or the like, and formed on a thin-film transistor (TFT) layer of the display module 100.

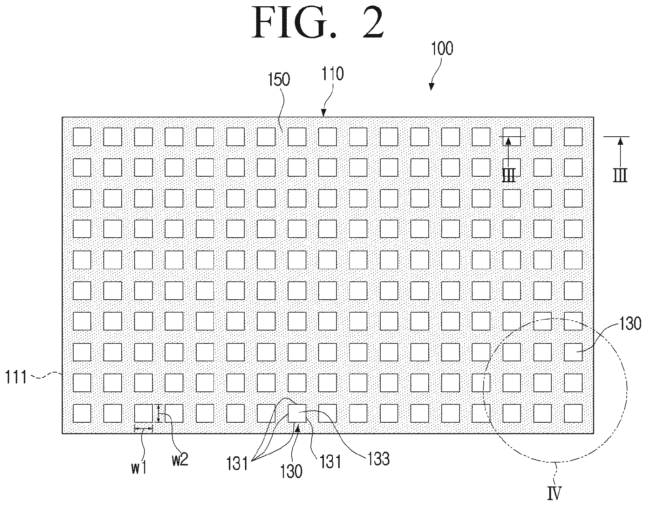

FIG. 2 is a view showing one of the plurality of display modules included in one display device.

Referring to FIG. 2, the display module 100 may include a printed circuit board 110, a plurality of light emitting elements (or luminous elements) 130 arranged on one surface of the printed circuit board 110 while having a predetermined gap therebetween, and a filling layer 150 formed on one surface of the printed circuit board 110 that is mounted with the plurality of light emitting elements 130.

The printed circuit board 110 may have a conductive pattern formed thereon. This conductive pattern may include a conductive pattern to be connected to the anode and cathode of each of the plurality of light emitting elements. This printed circuit board 110 may have a square shape to facilitate its connection with another adjacent display module 100. However, the printed circuit board 110 is not limited to this shape, and may have any shape that facilitates its connection with the adjacent printed circuit board 110. In addition, the printed circuit board may have a thickness t greater than a height h1 of the light emitting element 130.

In addition, the printed circuit board 110 is exemplified as being made of a flat surface, but is not limited thereto, and may be made of a curved surface having a predetermined curvature. In this case, display modules 100 may be connected with each other in the matrix to form one curved display device.

The plurality of light emitting elements 130 may be arranged on the printed circuit board while having a predetermined gap therebetween. For example, the plurality of light emitting elements 130 may be arranged in matrix form on one surface of the printed circuit board 110 while having a predetermined gap therebetween.

Each light emitting element 130 may have an approximately hexahedral shape, and may be a small or ultra-small LED having "width w1 x length w2 x height" of "1mm x 1mm x 0.7mm" or less. This numerical value is an example, and the light emitting element 130 may use a light emitting element smaller than the above-mentioned value or a light emitting element larger than the above-mentioned value. Meanwhile, the illustrated example shows and describes that the horizontal and vertical lengths of the light emitting element are the same as each other, and the horizontal and vertical lengths of the light emitting element may be implemented to be different from each other. This light emitting element may be referred to as a micro LED chip, a micro LED, or the like.

The light emitting element 130 may emit light through a top surface 133, and may have an anode electrode and a cathode electrode respectively disposed on its bottom surface. The anode electrode and the cathode electrode may each be connected to the conductive pattern formed on the printed circuit board 110. Meanwhile, the light emitting element 130 may also be implemented to emit light through a side surface 131.

In addition, the size of each light emitting element 130 may be small or ultra-small, thus the pitch g1 of each light emitting element 130 may be set to a very narrow gap, for example, 0.5 mm or less. The pitch g1 of each light emitting element 130 may preferably be set within a predetermined range (for example, 0.3 to 2 mm) based on a resolution of one display device 10 to be implemented.

The filling layer 150 may be disposed between the respective light emitting elements 130 so that the conductive pattern on the printed circuit board 110 is not exposed. Here, the filling layer 150 may have a height in which the filling layer 150 does not cover a top surface of each light emitting element 130. In addition, the filling layer 150 may cover all four side surfaces 131 of each light emitting element 130.

The filling layer 150 may be disposed between the respective light emitting elements 130 arranged approximately in the matrix, and disposed on an edge part 111 of the printed circuit board 110 while surrounding each side surface of the light emitting elements 130 arranged in its outermost region (here, the side surface refers to the side surface of the light emitting elements 130 that faces the edge part 111 of the printed circuit board 110). The printed circuit board has a protruding structure disposed in its outer region and having a predetermined height higher than a height of the conductive pattern and lower than each top surface of the plurality of light emitting elements to form this type of filling layer. Meanwhile, the above-mentioned protruding structure may remain in the display module based on an implementation method, or may be cut and removed from a final structure of the printed circuit board 110.

In this way, the filling layer 150 may cover a conductive material disposed on the printed circuit board 110, thus blocking a conductive foreign material from being in contact with the anode and cathode electrodes and safely protect the anode and cathode electrodes from static electricity in addition to making them waterproof and dustproof. Accordingly, it is possible to prevent a control circuit element from being short-circuited by the conductive foreign material or damaged by static electricity.

The filling layer 150 may be made of an opaque, non-conductive material, and in this case, may preferably further include elasticity. For example, the filling layer 150 may be made of silicone, acrylic resin, or epoxy resin. In this case, a coating solvent provided to form the filling layer 150 may have a viscosity of about 2000 to 9000 p (poise) to prevent excess flow or dripping after being discharged by a nozzle. In addition, the filling layer 150 may be made of a dark color, for example, black, to prevent reflection of light incident from the front of each light emitting element 130.

The filling layer 150 may have a height lower than a height of the top surface 133 of the light emitting element 130 so as not to cover the top surface 133 of each light emitting element 130. For example, a filling material may be discharged such that the height h3 of the filling layer 150 is lower than the height of the top surface 133 of each light emitting element 130. In this case, a top surface of the filling layer 150 may have a concave curved surface having a predetermined curvature towards one surface of the printed circuit board 110 due to surface tension until the filling solvent is cured. That is, the height of the filling layer 150 described above may be determined for the concave curved surface to have a height higher than the height of the conductive pattern on the printed circuit board. In other words, the lowest point of the curved surface of the filling layer is above the highest point of the conductive pattern.

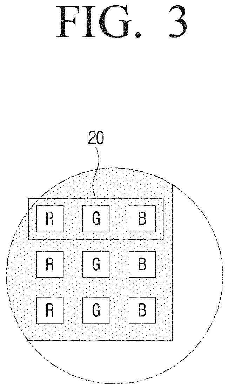

Meanwhile, FIGS. 2 and 3 show that the gap between the plurality of light emitting elements is the same both horizontally and vertically, but the horizontal gap and the vertical gap may be implemented to be different from each other. That is, the R light emitting element, the G light emitting element, and the B light emitting element may be arranged in a row as shown in FIG. 3. In this case, the vertical gap between the plurality of light emitting elements may be greater than the horizontal gap to allow the pixels included in the display module to have a predetermined gap therebetween. On the other hand, the plurality of light emitting elements may configure one cell in a vertical direction, and in this case, the horizontal gap between the plurality of light emitting elements may be larger than the vertical gap.

Meanwhile, a layer formed between the light emitting elements is shown and described hereinabove using the term "filling layer". However, this layer may be implemented to be referred to by a term such as a coating layer, an opaque layer, a non-conductive layer, a black layer, or the like.

Meanwhile, the display module 100 is shown and described hereinabove as including only the printed circuit board, the light emitting element, and the filling layer. However, the display module 100 may be implemented to have a driving circuit for driving the above-described light emitting element that is disposed on the back of the printed circuit board. In addition, additional molding layer, film, or the like may be disposed on the display module 100 (that is, on the light emitting element and the filling layer).

FIG. 3 is a view showing an arrangement example of the light emitting elements. In detail, FIG. 3 shows the arrangement example of the light emitting elements in region IV of FIG. 2.

Referring to FIG. 3, the plurality of light emitting elements may be arranged in matrix form on the printed circuit board, and the light emitting elements of the same color for each row may be arranged.

For example, the R light emitting elements may be arranged in a first row, the G light emitting elements may be arranged in a second row, and the B light emitting elements may be arranged in a third row. In addition, three light emitting elements (that is, the R light emitting element, the G light emitting element, the B light emitting element) for each column may be operated as one pixel 20. In this case, the R light emitting element, the G light emitting element, and the B light emitting element, included in one pixel, may be referred to as the R subpixel, the G subpixel, and the B subpixel.

Meanwhile, the illustrated example shows and describes that one pixel includes three light emitting elements. However, one pixel may be implemented to include four light emitting elements. In addition, the light emitting elements of the same color are shown and described as being arranged for each column, and the light emitting elements of the same color may be implemented to be arranged for each row.

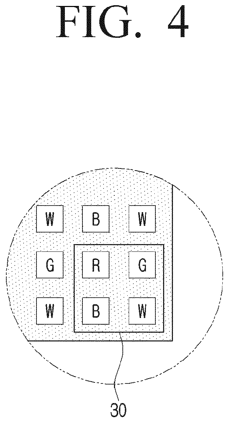

FIG. 4 is a view showing another arrangement example of the light emitting elements.

Referring to FIG. 4, the plurality of light emitting elements may be arranged in matrix form on the printed circuit board, and four light emitting elements arranged in a square shape may configure one pixel 30. For example, the R light emitting element may be disposed in a first upper left region, the G light emitting element may be disposed in an upper right region, the B light emitting element may be disposed in a lower left region, and the white (W) light emitting element may be disposed in a lower right region. In addition, this arrangement structure may be provided in the same form throughout the printed circuit board. Meanwhile, it is obvious that the light emitting elements within one pixel may be arranged in a different order than the illustrated example.

Meanwhile, the illustrated example shows and describes that one pixel is configured using four light emitting elements. However, one pixel may be implemented to be configured using three light emitting elements. For example, the R light emitting element, the G light emitting element, and the B light emitting element may be disposed in the illustrated four positions while having one position empty among the four positions (e.g., an L-shape).

Meanwhile, referring to FIGS. 3 and 4, the light emitting elements are shown and described as using light emitting elements of different colors, but may use one blue light emitting element. For example, all light emitting elements may use the blue light emitting elements, and each light emitting element may be implemented with a color filter for implementing a R, G, or B color. Here, the color filter may be a quantum dot (QD) color filter, but is not limited thereto.

Referring to FIGS. 3 and 4, it may be seen that the display module 100 uses light emitting elements configuring one subpixel and disposed directly on the printed circuit board rather than using a light emitting element module operating as one pixel.

Meanwhile, the conductive pattern on the printed circuit board is exposed to bond the plurality of light emitting elements to the printed circuit board. Here, unlike a package-type module, in case of a chip-type light emitting element, the conductive pattern disposed on the circuit board may be often visible upward even in case that the light emitting element is bonded to the printed circuit board.

Such a conductive pattern (for example, a copper foil) may reflect light, and may affect an image quality during an image display operation. Therefore, it is necessary to cover the conductive pattern with an opaque non-conductive material so as not to expose the conductive pattern.

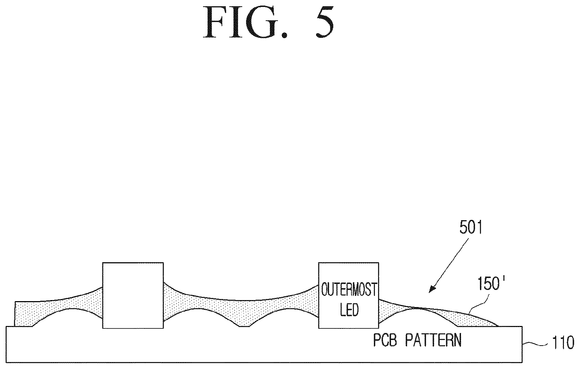

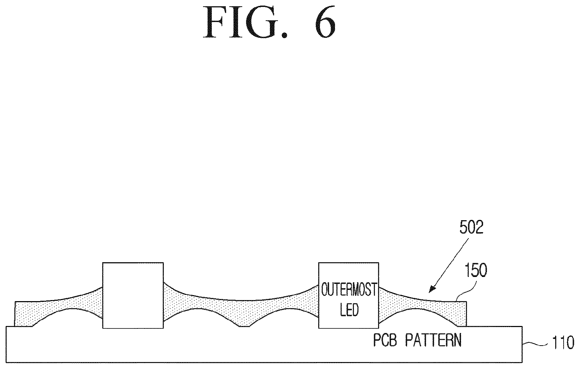

Hereinafter, the description describes a filling operation to prevent the exposure of the conductive pattern with reference to FIGS. 5 and 6.

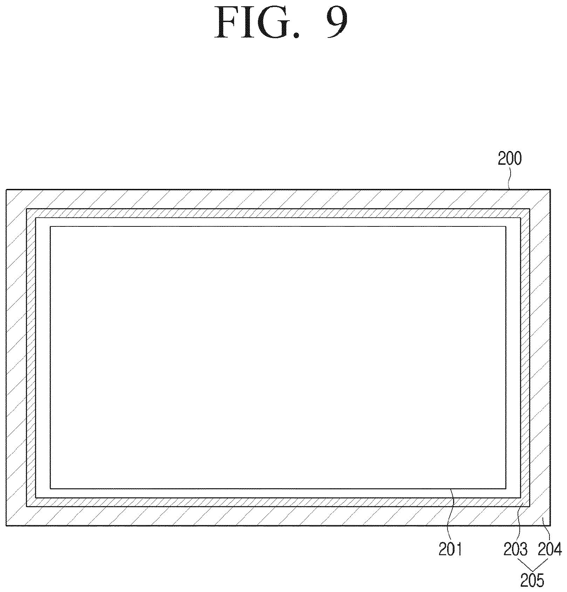

Each of FIGS. 5 and 6 is a cross-sectional view of the display module taken along line III-III shown in FIG. 2. In detail, FIG. 5 shows the case of depositing the filling material by using a printed circuit board without a separate protruding structure, and FIG. 6 shows the case of depositing the filling material by using a printed circuit board having the protruding structure as shown in FIG. 9.

Referring to FIG. 5, the filling material may be disposed between the plurality of light emitting elements in case that the filling material (in detail, the opaque non-conductive material) is coated on the printed circuit board 110 on which the plurality of light emitting elements are arranged. However, it may be seen that the filling material is deposited in the space between the plurality of light emitting elements such that the conductive pattern (PCB Pattern) that is disposed lower than the light emitting elements is covered, but the outermost region between the outermost light emitting elements and the edge of the printed circuit board 110 is covered with the filling material in a way that the conductive pattern is not covered. In detail, it may be seen that the filling material in the regions between the light emitting elements is supported by side surfaces of the light emitting elements. In contrast, in the outermost region beyond the outermost light emitting elements, only one part of the filling material is supported by the side surface of the light emitting element and the opposing part is not supported, so that the filling material 150' spreads in the region that is unsupported, towards the edge of the printed circuit board, thus exposing some of the conductive pattern 501.

The display module formed in this way may reflect light input from the outside as the conductive pattern is exposed in the outer region, thereby causing light interference and color interference such as a white seam.

To solve this problem, a printed circuit board having a protruding structure is used. An example of the printed circuit board is described in detail with reference to FIG. 9.

By using the printed circuit board as described, filling material at an inner side of the outermost region is supported by a side wall of the outermost light emitting element and the outer side is supported by the protruding structure to prevent the filling material from spreading in the process of depositing the filling material. That is, as shown in FIG. 6, the filling material may effectively cover the conductive pattern on the printed circuit board even in the outer region.

Although FIG. 6 does not show the protruding structure itself, this illustration is provided for comparison with FIG. 5 to illustrate the effect of using the protruding structure. The protruding structure may be implemented to be disposed in the outermost region between the outermost light emitting element and the edge of the printed circuit board. In addition, FIG. 6 shows that the filling material in the outermost region and the printed circuit board 110 have a step existing therebetween, but may be implemented to be formed in a straight line.

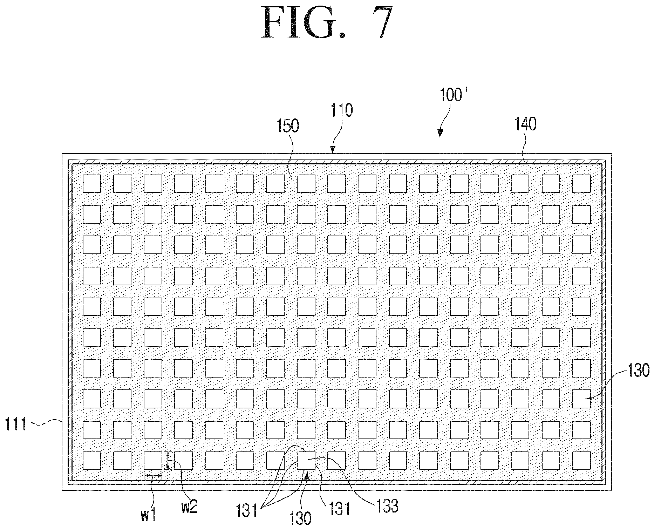

FIG. 7 is a view showing an example of the display module according to an embodiment of the invention. In detail, FIG. 7 shows an example of the display module in the case that the outer region of the printed circuit board where the protruding structure is disposed is not cut in a manufacturing process of the display module.

In detail, comparing FIG. 2 with FIG. 7, a display module 100' may have a protruding structure 140 disposed in the outer region of the printed circuit board.

As described above with reference to FIG. 6, the protruding structure 140 may prevent the non-conductive material from spreading to the edge part of the printed circuit board in the process of filling the opaque non-conductive material between the outermost light emitting element disposed and the edge part 111 of the printed circuit board.

Meanwhile, the printed circuit board 110, the plurality of light emitting elements 130, and the filling layer 150 other than the protruding structure 140 are described above with reference to FIG. 2, and their redundant descriptions are thus omitted.

FIG. 7 shows that the protruding structure 140 is spaced apart from the edge part 111 of the printed circuit board 110 by a predetermined gap. However, the outermost wall of the protruding structure and the outermost region of the printed circuit board 110 may be implemented to coincide with each other.

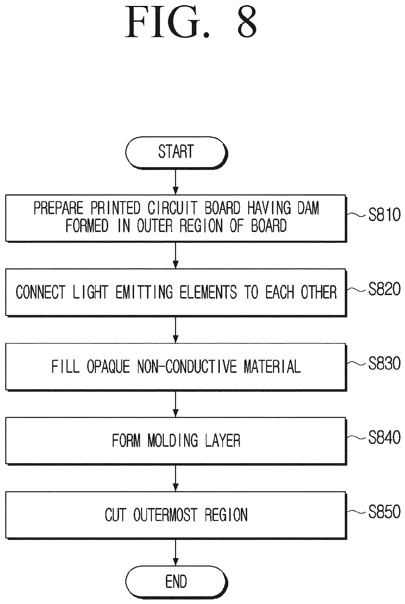

Hereinafter, the manufacturing method of a display module according to the invention is described in detail with reference to FIGS. 8 to 21.

FIG. 8 is a flowchart for explaining the manufacturing method of a display module according to an embodiment of the invention.

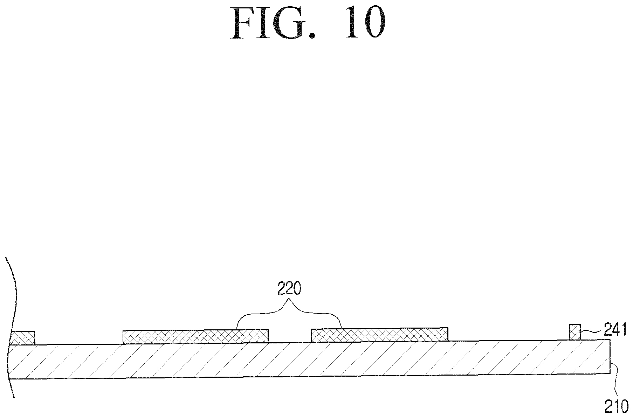

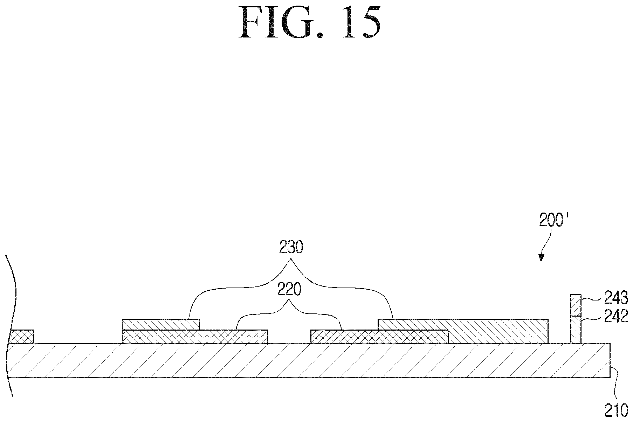

Referring to FIG. 8, a printed circuit board having the conductive pattern and the protruding structure, also referred to as a dam, having a predetermined height in the outer region are prepared (S810). For example, the printed circuit board as shown in FIG. 10 or FIG. 15 may be prepared. The specific configuration and operation of the printed circuit board is described below with reference to FIGS. 9 to 15.

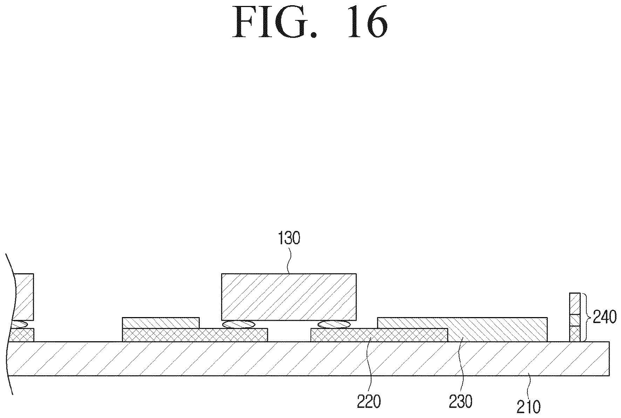

In addition, the plurality of light emitting elements may be electrically connected to the conductive pattern for the plurality of light emitting elements to be arranged while having the predetermined gap therebetween (S820). This may be expressed as transferring the light emitting elements to the printed circuit board or bonding the light emitting elements to the printed circuit board. For example, each light emitting element may be bonded to the printed circuit board by using a flip chip method. The plurality of light emitting elements may be bonded to the printed circuit board to thus produce a form shown in FIG. 16.

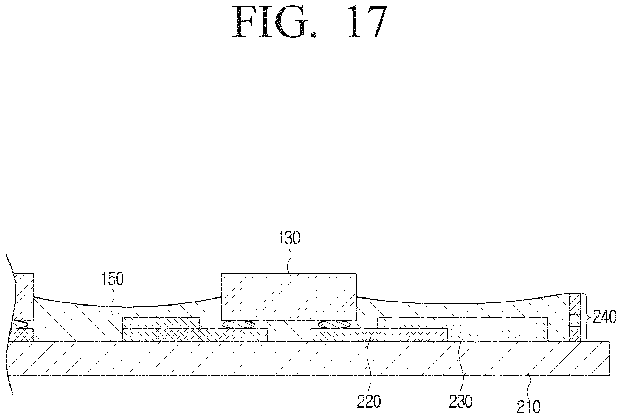

In addition, the opaque non-conductive material may fill the region between the plurality of light emitting elements and the outer region between the outermost light emitting elements and the protruding structure so that the conductive pattern is not exposed(S830). For example, the opaque non-conductive material may be discharged to and fill the printed circuit board to a height corresponding to, for example the same as, the height of the protruding structure. The filling of the non-conductive material may be performed through this operation to thus produce the form shown in FIG. 17. In addition, an operation of curing the opaque non-conductive material filling the printed circuit board may be performed after the filling. For example, the curing operation may be performed such as leaving the opaque non-conductive material for a sufficient time, adjusting a predetermined temperature condition, or the like to cure the same.

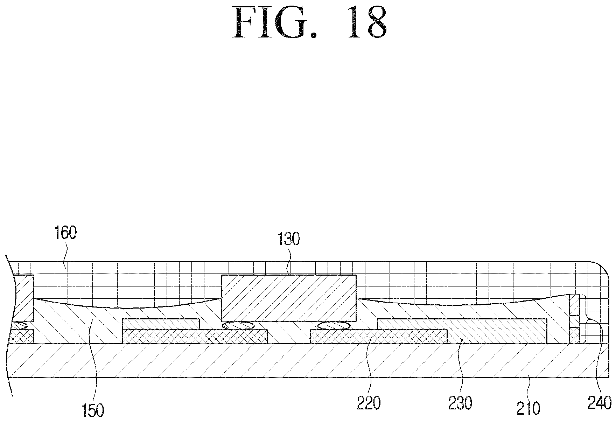

In addition, a molding layer (160) may be formed on the plurality of light emitting elements and the filling layer (S840). This molding layer may be formed to thus provide the printed circuit board having the form shown in FIG. 18.

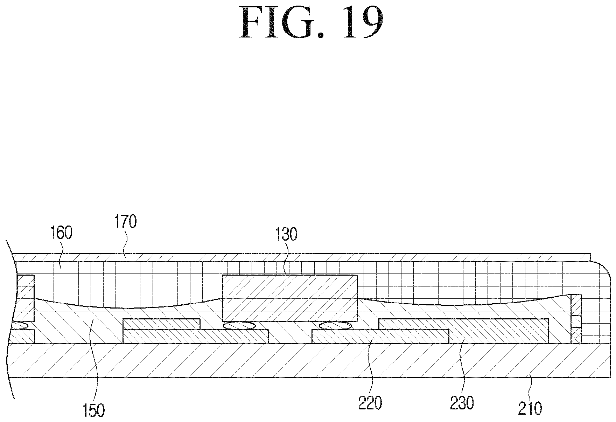

In addition, a film layer (170) may be formed on the molding layer. This film layer may be formed sequentially in this way to thus provide the printed circuit board having the form shown in FIG. 19. Meanwhile, the manufacturing method may be implemented to omit operations of the molding layer and the film layer forming operation or a process of forming the film layer.

In addition, the display module may be finally formed by cutting the outer region of the printed circuit board on which the film layer is formed (S850). In detail, the outer region may be cut using a mechanical cutting method or a laser cutting method using a laser.

The manufacturing method may omit this cutting process, and may be implemented to cut all the outer regions, or only the outer region corresponding to a partial edge of the outer region. Meanwhile, the manufacturing method may be implemented not only to entirely cut the outer region, but also to cut around a region where a protruding structure is disposed, or to perform the cutting based on an outer surface of the protruding structure to thus maintain the protruding structure (or a portion of the protruding structure).

Meanwhile, in addition to the processes described above, the manufacturing method may be implemented to have an additional process as a subsequent post-process, or have a process not described above that is added between the above-described processes. Hereinafter, a specific operation of each of the plurality of processes described above is described with reference to FIGS. 9 to 21.

FIG. 9 is a plan view for explaining the printed circuit board according to an embodiment of the invention.

Referring to FIG. 9, a printed circuit board 200 has a conductive pattern formed thereon and a protruding structure higher than the conductive pattern and disposed in the outer region. In detail, the printed circuit board may have an inner region 201 where various circuits are disposed and an outer region 205 which is cut in a later process.

The inner region 201 may have various conductive patterns where the plurality of light emitting elements are to be arranged and a resist pattern protecting a portion of the conductive pattern.

The conductive pattern may be a pattern formed of the conductive material for connecting the anode and cathode of each of the plurality of light emitting elements to each other. This conductive pattern may be referred to as a wire circuit and may be formed of a material such as copper foil.

The resist pattern may be a pattern covering the conductive pattern, and include a coating layer preventing solder from wetting beyond the region where the component is to be mounted to prevent an unintended connection from occurring due to soldering (or component connection) performed when mounting the component on the printed circuit board. The resist pattern may be referred to as a solder mask. The resist pattern may prevent circuit short-circuiting, printed circuit board short-circuiting, corrosion contamination, or the like. The resist pattern may be the same as the core material of the printed circuit board. The resist pattern may be thermosetting resin and use epoxy resin, polyimide resin, Bismalemide Triazine (BT) resin, or Teflon resin.

The outer region 205 of the printed circuit board 200 may include a region 203 where the protruding structure is formed and a region 204 outside the protruding structure. For example, the region 203, where the protruding structure is formed, may be disposed at a distance from the outermost light emitting element by a distance proportional to the pitch corresponding to an arrangement gap between the plurality of light emitting elements. As an example, the distance may be half the pitch or a distance corresponding to the pitch.

That is, the display module may not be operated independently, and instead operated by being disposed to be adjacent to another display module. In detail, referring to part V of FIG. 1, the outermost light emitting element of one display module may be adjacent to the outermost light emitting element of another display module, and it is preferable that a distance between the two light emitting elements is similar to the gap between light emitting elements within another internal display module. In this regard, the gap between the outermost light emitting element and the protruding structure may be determined by considering the proximity to other display modules and process errors during the cutting process.

As described above, the protruding structure may be disposed in the outer region 205 while surrounding the inner region 201, and have a predetermined height. For example, the protruding structure may be spaced apart from the region where the outermost element among the plurality of light emitting elements is disposed by a predetermined gap. Here, the predetermined gap may be a distance spaced apart by a second gap corresponding to the gap between the outermost light emitting element among the plurality of light emitting elements and the plurality of light emitting elements (that is, the pitch between the light emitting elements). For example, the second gap may be half the pitch or a gap corresponding to the pitch between the light emitting elements.

The protruding structure may be a structure in which a copper foil layer, a solder resist layer, and a silk ink layer are sequentially stacked. Alternatively, the protruding structure may be a structure in which the solder resist layer and the silk ink layer are sequentially stacked. This protruding structure is referred to as having a protruding form on the printed circuit board, and may also be referred to as a dam structure, a dam member, or the like.

Hereinafter, the description first describes a manufacturing operation of the printed circuit board 200 having the protruding structure including a copper foil layer, a solder resist layer, and a silk ink layer with reference to FIGS. 10 to 12.

First, referring to FIG. 10, a conductive pattern 220 may be formed on a board 210. A copper foil layer 241 may also be formed in an outer region of the board 210 in addition to the pattern for electrical connection between a plurality of light emitting circuits. Here, a height of the copper foil layer disposed in the outer region may be the same as the height of the copper foil layer (or conductive pattern) disposed in an inner region of the board, and the copper foil layer 241 may include the same material as the conductive pattern formed in the inner region 201.

Meanwhile, the conductive pattern 220 and the copper foil layer 241 may be individually implemented through separate processes. In this case, the heights of the conductive pattern 220 and the copper foil layer 241 may be different from each other.

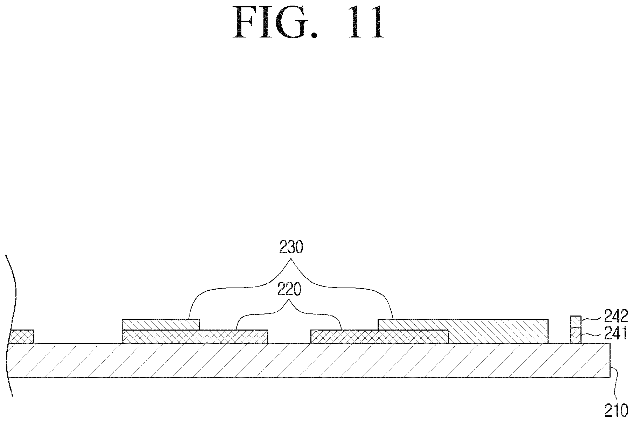

In addition, referring to FIG. 11, a solder resist layer 230 may be formed on the board on which the conductive pattern 220 is formed. Here, a solder resist layer 242 may also be formed in the outer region of the board (that is, the region where the protruding structure is to be disposed). The solder resist layer may be formed simultaneously in the inner region and the outer region. In this case, the two solder resist layers 230 and 242 may have the same material, and the same height.

The illustrated example shows and describes that the solder resist layer is formed simultaneously in the outer region and the inner region through one process. However, the inner region may be implemented to be formed first, and the outer region may be implemented to be formed through a separate process. In this way, the solder resist layers may be formed individually. In this case, the two solder resist layers 230 and 242 may have different heights.

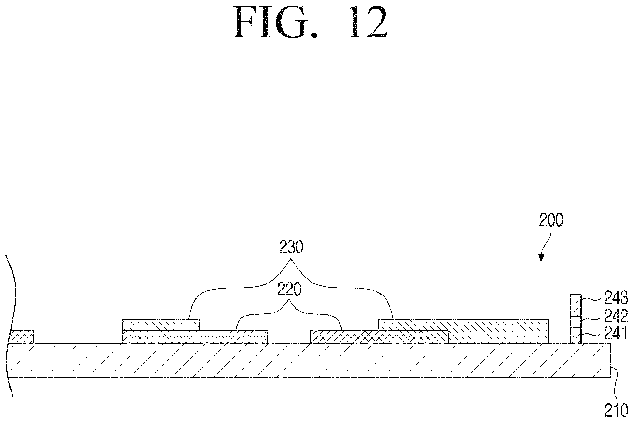

In addition, referring to FIG. 12, a silk ink (silkscreen) layer 243 may be formed in the outer region of the board. In detail, the silk ink layer 243 may be formed to have a predetermined height corresponding to the height of a light emitting element bonded to the conductive pattern on the solder resist layer 230.

The silk ink layer 243 may be formed on the solder resist layer 242, and may be formed using thermosetting ink or infrared curing ink. The top of the silk ink layer defines the height of the protruding structure. For example, the top of the silk ink layer may be lower than the light emitting element disposed on the printed circuit board, and may be higher than a midheight of the light emitting element. The silk ink layer 243 may have this height to prevent excessive spread of the non-conductive material in the outermost region in the process of filling the non-conductive material, as described above. That is, the silk ink layer 243 may have this height to prevent the conductive pattern from being exposed on the printed circuit board after being filled with the non-conductive material. Therefore, the silk ink layer 243 may have various heights as long as the silk ink layer 243 has a minimum height to achieve the above-mentioned purpose.

It has been described that a protruding structure 240 is implemented using the copper foil layer 241, the solder resist layer 242, and the silk ink layer 243. However, the copper foil layer 241 and the solder resist layer 242 may be formed through the same process as the component disposed in the inner region 201. In this case, the protruding structure 240 may have the required height by adjusting the height of the silk ink layer 243.

Although the silk ink layer 243 may use a material such as silk ink, it is not limited thereto, and may use various materials such as Teflon or primer.

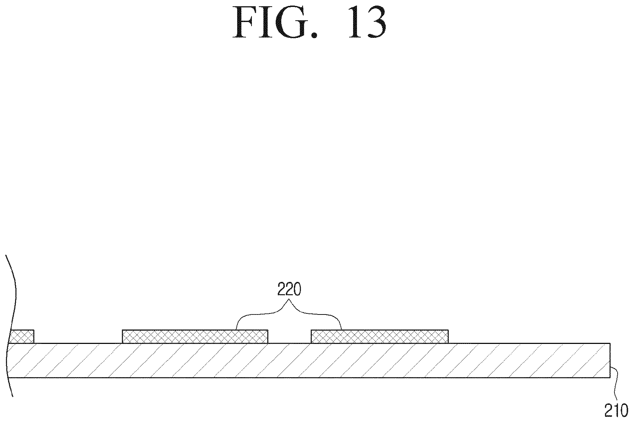

The description describes hereinabove the manufacturing method of a printed circuit board having the protruding structure including three layers. However, the protruding structure may be implemented to include only two layers. This configuration is described with reference to FIGS. 13 to 15.

First, referring to FIG. 13, the conductive pattern 220 may be formed on the board 210. Comparing with FIG. 10, it may be seen that in FIG. 13, the conductive pattern is formed only in the inner region, and the conductive pattern is not disposed in the outer region where the protruding structure is to be disposed.

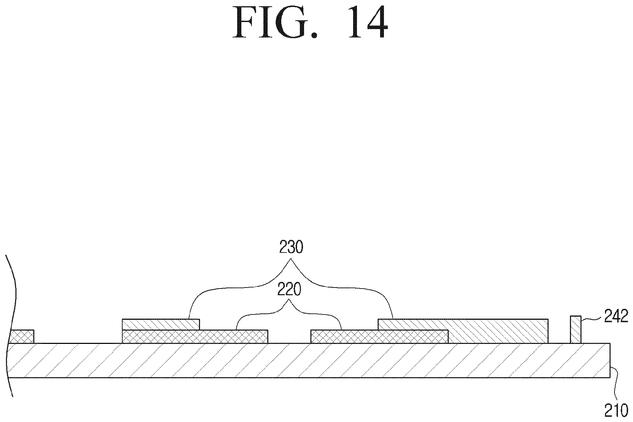

Next, referring to FIG. 14, the solder resist layer 230 may be formed on the board on which the conductive pattern 220 is formed. Here, the solder resist layer 242 may also be formed in the outer region of the board (that is, the region where the protruding structure is to be disposed). The solder resist layer may be formed in the inner region and outer region of the board. In this case, the two solder resist layers may have the same material and also the same height.

Meanwhile, the solder resist layers may each be implemented to be formed individually in the outer region and inner region of the board. In this case, the two solder resist layers 242 and 230 may be made of different materials or may have different heights.

In addition, referring to FIG. 15, the silk ink layer may be formed in the outer region of the board. In detail, the silk ink layer 243 may be formed to have the predetermined height corresponding to the height of the light emitting element bonded to the conductive pattern on the solder resist layer 230.

Meanwhile, referring to FIGS. 10 to 15, the above-described protruding structure is shown and described to be constructed using the three components (i.e., the copper foil layer, the solder resist layer, and the silk ink layer) or the two components (i.e., the solder resist layer and the silk ink layer), that is, a method of forming also the solder resist layer (or the copper foil layer and the solder resist layer) included in the protruding structure in a process of forming the structure in the central region within the printed circuit board. However, a process of forming the protruding structure in the outer region may be implemented to be performed after forming the structure in the inner region.

In addition, the illustrated example shows that three materials (or two materials) included in the protruding structure are formed in the form of vertical walls. However, one side surface of the protruding structure may be inclined, and a width of each layer may become gradually smaller.

Meanwhile, only the configuration on the printed circuit board is shown and described hereinabove. However, the driving circuit for driving the plurality of light emitting elements may be disposed in a lower part of the printed circuit board (that is, a region opposite to the region where the plurality of light emitting elements are arranged).

A subsequent manufacturing method of the display module is described as using the printed circuit board shown in FIG. 12. However, the method may use the printed circuit board shown in FIG. 15. In addition, the display module using the printed circuit board provided with additional components not shown in FIG. 12 or FIG. 15 may also be manufactured.

The plurality of light emitting elements 130 may be glued (or installed, attached, bonded) on the printed circuit board in case that the printed circuit board 200 or 200' having the protruding structure is prepared in this way. For example, each of the plurality of light emitting elements 130 may be disposed on the conductive pattern where the light emitting element is to be disposed, and attached to the printed circuit board by using the flip chip method. Here, the flip chip method may be a method of forming a bump on a chip pad and connecting the chip to the printed circuit board.

Meanwhile, the description describes hereinabove the method of attaching the printed circuit board to the plurality of light emitting elements by using the flip chip method. However, another bonding method, such as wire bonding or bonding using an anisotropic conductive film (ACF), may be implemented to be used as an alternative or in addition to this method.

In addition, the bonding of the light emitting elements described above may use not only a method of bonding the light emitting elements in a single unit, but also a method of bonding the plurality of light emitting elements in a plurality of units. For example, the bonding may use a method of simultaneously bonding the R light emitting elements to each other, then simultaneously bonding the G light emitting elements to each other, and then simultaneously bonding the B light emitting elements to each other.

This process may be performed to thus produce the form shown in FIG. 16.

FIG. 16 is a view for explaining a state where the light emitting element is disposed on the printed circuit board.

Referring to FIG. 16, it may be seen that the plurality of light emitting elements 130 are bonded to the printed circuit board 200, and the protruding structure 240 is disposed in the outer region. Here, it may be seen that the protruding structure 240 has the height lower than the installed light emitting element, and has the height higher than the resist layer.

In this way, the protruding structure may be disposed in the outer region. Accordingly, in the process of filling the non-conductive material between the plurality of light emitting elements, the non-conductive material may be trapped by the protruding structure in the outermost region (in detail, between the outermost light emitting element and the edge part of the printed circuit board).

The illustrated example shows that the protruding structure 240 is lower than the top surface of the light emitting element. However, the height of the protruding structure may be the same as the top of the light emitting element. Alternatively, the protruding structure 240 may be implemented to be higher than the height of the light emitting element. However, if the height of the protruding structure is excessively high, in the bonding process of the light emitting element, movement of a bonding mechanism or the like may be restricted due to the height of the protruding structure. Therefore, the protruding structure may have the height provided considering the movement of the bonding mechanism (or machine) for the light emitting element.

In case of preparing the printed circuit board to which the light emitting elements are bonded in this way, the non-conductive material may fill the space between the plurality of light emitting elements and the space between the outermost light emitting element and the protruding structure. For this process, a discharge device discharging the non-conductive material may be used. For example, the discharge device may be a device discharging the material by operating a piezo valve.

Meanwhile, in the disclosure, the gap between the respective light emitting elements may be less than 2mm, and the above-described discharge device may be required to discharge the filling material into a very narrow gap. Therefore, the nozzle of the discharge device may have a diameter d smaller than the gap described above. In addition, the diameter d of the nozzle may be provided considering a condition that a coating solvent L may not be deposited on the top surface of each light emitting element 130 in case that the coating solvent L is discharged. In addition, the coating solvent L may have viscosity of approximately 2000 to 9000 p (poise) for its flow speed from one surface of the printed circuit board 210 to be slow (or for its shape to be maintained to a certain degree) after being discharged by a nozzle 330.

The discharge device may discharge a predetermined amount of discharged material while being moved along X and Y axes between the respective light emitting elements at a predetermined speed.

In this way, the discharge device may cover all the patterns 220 and 230 on the printed circuit board by discharging the discharged material (that is, the non-conductive material) in the space between the plurality of light emitting elements, as well as in the space between the outermost light emitting element and the protruding structure.

Meanwhile, the description describes hereinabove that the printed circuit board having the protruding structure is used to prevent the above-described discharged material from spreading in the outermost region. Meanwhile, instead of using the printed circuit board described above, a jig may be installed in the outer region of the printed circuit board and used to prevent the discharged material from spreading. It is possible to use the jig in case of using a relatively large light emitting element. However, in case of using a micro-sized light emitting element, the following problems may occur in case of using the jig.

In detail, due to a gap between the jig and the printed circuit board, the discharged material may pass through between the jig and the printed circuit board, thus causing a bad result in the bonding between the display modules. That is, even though fine connection between the display modules is necessary, the connection between the display modules may become inaccurate due to the discharged material stuck between the jig and the printed circuit board. In addition, in case of using the jig, a process time required to install and remove the jig from the outer region of the printed circuit board may be increased. In addition, if the discharged material is stuck to the jig, the discharged material may be separated in a direction of the jig rather than remaining on the printed circuit board in case of separating the jig.

FIG. 17 is a view showing a state where the non-conductive material completely fills the space between the respective light emitting elements of the display module and the space between the outermost light emitting element and the protruding structure.

As shown in FIG. 17, in the case that the non-conductive material fills the space to a predetermined height, the material may be cured for a predetermined time.

In case that the non-conductive material is completely cured, the filling layer 150 is formed on the printed circuit board. A molding material may then be coated to secure each component on top of the display module. The molding material may cover not only the top of the light emitting element but also the filling layer. In addition, the molding material may be a transparent material for light from the light emitting element to pass through the top.

FIG. 18 is a view showing a state of the printed circuit board formed with the molding layer 160.

Referring to FIG. 18, the molding layer may cover not only the plurality of light emitting elements but also the filling layer.

In case that the molding layer is formed in this way, a film layer 170 (or the film) may be disposed on the molding layer. The illustrated example shows that the film layer has an area smaller than the top of the molding layer. However, the film layer may be implemented to have the same area as the top of the molding layer or to have an area larger than the top of the molding layer. In addition, the film layer may be a film having a specific optical feature. For example, the film layer may use an ultra-low reflection film.

FIG. 19 is a view showing a state of the printed circuit board formed with the film layer.

Referring to FIG. 19, it may be seen that the film layer is disposed on the molding layer 160. A film layer 170 may be formed, and all the components of the display module may be formed.

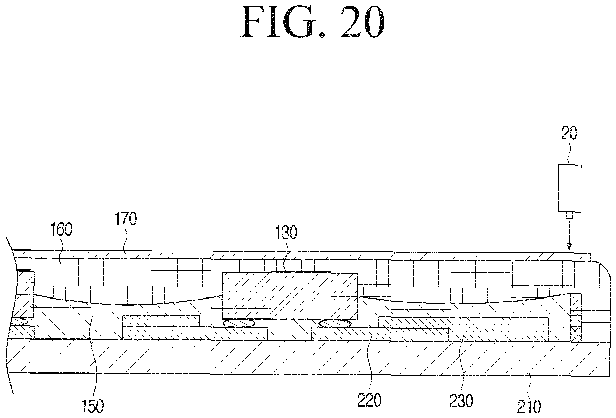

However, as shown in the drawing, the outer region of the printed circuit board may have a distance wider than half the pitch, which is the gap between the light emitting elements. Therefore, if the display module is bonded (or disposed) in a current state, the gap between the light emitting elements in the outer region of the display module may be wider than the gap between the light emitting elements disposed in the central region. In this case, a cutting operation as shown in FIG. 20 described below may be performed.

FIG. 20 is a view for explaining a process of cutting the outer region.

Referring to FIG. 20, a laser device 50 may be used to cut the outer region of the printed circuit board. Meanwhile, the outer region is shown hereinabove to be cut using a laser cutting method using the laser device. However, the outer region may also be implemented to be cut using a mechanical cutting method such as a milling device.

Meanwhile, the outer region of the display module is described hereinabove as being completely cut. However, only some regions of the outer region may be implemented to be cut. For example, the display module 100 may be disposed in the outermost region included in the display device. In this case, an edge region may not be adjacent to another display module. Therefore, the above-described cutting may be performed only on the region adjacent to another display module. For example, if the display module 100 is a module disposed on the upper left side of the display device as shown in FIG. 1, the cutting may be performed only on the right edge and bottom edge of the display module 100.

In addition, the illustrated example shows that the cutting is performed to remove the protruding structure. However, a cut position is disposed on the protruding structure or between the protruding structure and the outer region of the board, and the cutting may thus be performed in such a way that the protruding structure remains or some regions of the protruding structure remain.

Meanwhile, the outer region of the display module is shown and described hereinabove as being cut after forming the film layer. However, the outer region may be implemented to be cut before forming the film layer, and the film layer may be formed on a cut structure. In addition, the above-described cutting may also be performed before forming the film layer or before forming the molding layer.

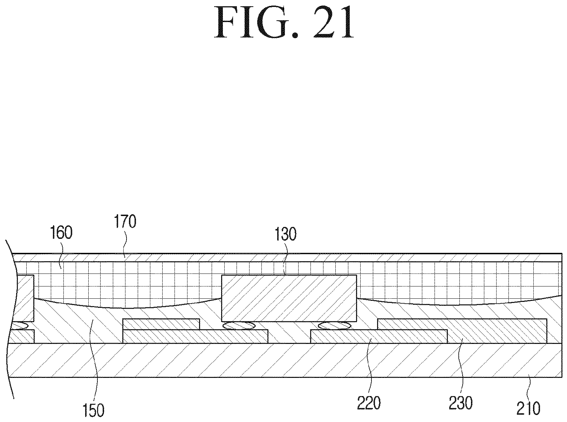

FIG. 21 is a view showing a cut result of FIG. 20.

Referring to FIG. 21, the outer region of the printed circuit board may be cut in this way. Accordingly, even if the display modules are in contact with each other, the gap between light emitting elements arranged in the different outermost regions of the display module may also be the same (or similar) as the gap between the light emitting elements arranged in the center.

In addition, as seen from the drawing, in the above-mentioned process, the protruding structure may prevent the internal filling material from excessively spreading in the outer region of the printed circuit board. Therefore, the filling material in the outer region may maintain a predetermined height, thus preventing the conductive pattern in the outermost region from being exposed. Accordingly, even if light enters the printed circuit board from the top surface of the display module, the conductive pattern exposed to the printed circuit board may become invisible, thereby allowing the outer region of the display module to also maintain the same light reflection performance as the central region.

Although embodiments of the invention have been shown and described hereinabove, the invention is not limited to the above-mentioned specific embodiments, and may be variously modified by those skilled in the art to which the disclosure pertains without departing from the scope of the invention as set out in the accompanying claims.

## Claims

1. A display module comprising:
a printed circuit board (210) having a conductive pattern (220) formed thereon;
a plurality of light emitting elements (130) arranged on the printed circuit board (210), and electrically connected to the conductive pattern; and
a filling layer (150) including an opaque non-conductive material;
wherein the printed circuit board comprises a protruding structure (240) disposed in an outer region of the printed circuit board (210) between outermost ones of the light emitting elements (130) and an edge of the printed circuit board, wherein the height of the protruding structure (240) is greater than the height of the conductive pattern (220);
wherein the filling layer (150) is disposed between the plurality of light emitting elements (130) and between the outermost light emitting elements and the protruding structure (240) to cover the conductive pattern (220).

2. The module of claim 1, wherein the height of the protruding structure is less than the height of the top surface of each of the plurality of light emitting elements.

3. The module of claim 1, wherein the protruding structure comprises a copper foil layer, a solder resist layer and a silk ink layer that are sequentially stacked on the printed circuit board.

4. The module of claim 3, wherein the copper foil layer has the same height as the conductive pattern, and
the solder resist layer has the same height as a resist pattern formed to protect the conductive pattern.

5. The module of claim 1, wherein the protruding structure comprises a solder resist layer and a silk ink layer that are sequentially stacked on the printed circuit board.

6. The module of claim, wherein the protruding structure surrounds the plurality of light emitting elements.

7. The module of claim 6, wherein the protruding structure is spaced apart from the outermost light emitting elements among the plurality of light emitting elements by a predetermined gap, wherein the predetermined gap is the same as or is half the gap between adjacent ones of the plurality of light emitting elements.

8. The module of claim 1, further comprising:
a molding layer disposed on the plurality of light emitting elements and the filling layer; and
a film layer disposed on the molding layer.

9. The module of claim 1, wherein each of the plurality of light emitting elements is at least one of a red (R) light emitting element, a green (G) light emitting element, or a blue (B) light emitting element, and
at least one R light emitting element, at least one G light emitting element, and
at least one B light emitting element among the plurality of light emitting elements is operated as one pixel.

10. The module of claim 1, wherein the height of the filling layer is less than the height of the top surface of each of the plurality of light emitting elements.

11. A manufacturing method of a display module, the method comprising: preparing a printed circuit board having a conductive pattern formed thereon and a protruding structure in an outer region of the printed circuit board;
connecting a plurality of light emitting elements to the conductive pattern; and
depositing an opaque non-conductive material between the plurality of light emitting elements and between outermost ones of the light emitting elements and the protruding structure to form a filling layer to cover the conductive pattern.

12. The method of claim 11, wherein in the deposing of the opaque non-conductive material, the opaque non-conductive material is discharged to fill the printed circuit board to a height corresponding to the height of the protruding structure.

13. The method of claim 11, further comprising:
forming a molding layer on the plurality of light emitting elements and the filling layer;
forming a film layer on the molding layer; and
cutting the outer region of the printed circuit board on which the film layer is formed.

14. The method of claim 13, wherein the molding layer is formed using a transparent material.

15. The method of claim 11, wherein each light emitting element is connected to the printed circuit board by using a flip chip method.
